# EUROPEAN PATENT SPECIFICATION

(11) **EP 3 872 953 B1**
(45) Date of publication and mention of the grant of the patent: **04.12.2024**
(21) Application number: 21159360.3
(22) Date of filing: 25.02.2021
(51) Int. Cl.: H02J 7/00, H02H 7/18

(54) **BATTERY SYSTEM**
BATTERIESYSTEM
SYSTÈME DE BATTERIE

(30) Priority: 25.02.2020 KR 20200023000
(43) Date of publication of application: 01.09.2021
(73) Proprietor: Samsung SDI Co., Ltd., Yongin-si, Gyeonggi-do 17084 (KR)
(72) Inventor: JEON, Peelsik, 17084 Yongin-si (KR); JEON, Inbeom, 17084 Yongin-si (KR); MUN, Seongjin, 17084 Yongin-si (KR)
(74) Representative: Marks & Clerk LLP

(56) References cited:
- WO-A1-2018/100531
- CN-A- 110 466 387
- US-A1- 2009 208 821
- US-A1- 2011 285 351

## Description

### BACKGROUND

### 1. Field

One or more embodiments relate to a battery system, and more particularly, to a battery system including a battery disconnection unit (BDU).

### 2. Description of Related Art

Secondary batteries having electrical characteristics such as high energy density are variously used in portable devices as well as electric vehicles (EVs) or hybrid electric vehicles (HEVs) driven by electric power. Secondary batteries are attracting attention as a new energy source for eco-friendless and energy efficiency improvement in that these secondary batteries do not generate by-products caused by the use of energy as well as the primary advantage of dramatically reducing the use of fossil fuels.

Types of secondary batteries that are currently widely used include lithium ion batteries, lithium polymer batteries, nickel cadmium batteries, nickel hydride batteries, and nickel zinc batteries. The operating voltage of this unit secondary battery cell, i.e., a unit battery cell, is about 2.5 V to about 4.3 V. Thus, when a higher output voltage is required, a battery module is configured by connecting a plurality of battery cells in series. A battery module is also configured by connecting a plurality of battery cells in parallel according to the charge/discharge capacity required for the battery module. In addition, when a high output voltage of several hundred V or more is required, a battery system may be configured by connecting a plurality of battery modules in series. The number and connection configuration of battery cells that constitute the battery system may be variously set according to the required output voltage and charge/discharge capacity.

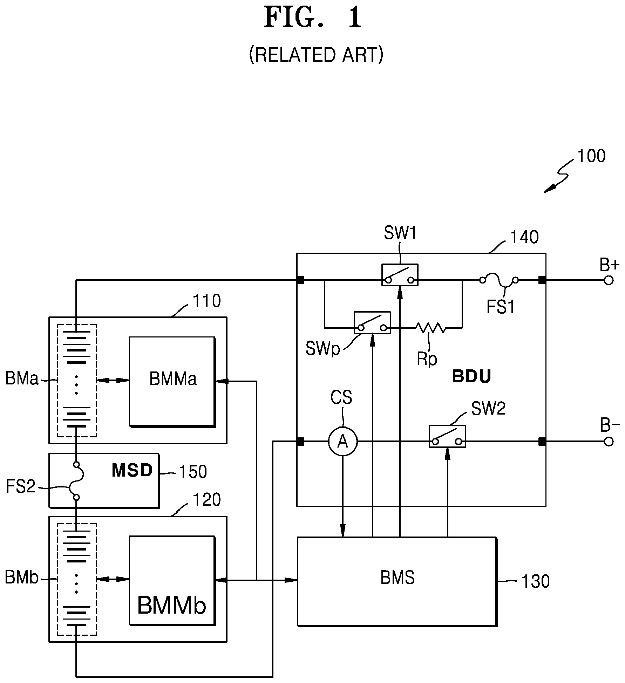

FIG. 1 is a block diagram of a battery system according to the related art.

Referring to FIG. 1, a battery system 100 includes a first battery module 110 and a second battery module 120 connected in series with each other. The first battery module 110 includes first battery cells BMa and a first battery management module BMMa, and the second battery module 120 includes second battery cells BMb and a second battery management module BMMb.

The battery system 100 includes a battery disconnection unit (BDU) 140. The battery disconnection unit (BDU) 140 may control a current flow on a high voltage path of the battery system 100, i.e., a path between the first battery module 110 and a first battery terminal B+.

The battery disconnection unit (BDU) 140 may include a first main switch SW1, a precharge switch SWp, a precharge resistor Rp, and a first fuse FS1 arranged on the high voltage path. The battery disconnection unit (BDU) 140 may include a second main switch SW2 and a current sensor CS arranged on a low voltage path, i.e., a path between the second battery module 120 and a second battery terminal B-.

The battery system 100 includes a battery management unit 130 that transmits/receives data to/from the first and second battery management modules BMMa and BMMb so as to manage the first and second battery modules 110 and 120. The battery management unit 130 controls the first and second main switches SW1 and SW2 and the precharge switch SWp and receives a signal corresponding to the magnitude of current detected by the current sensor CS.

The battery system 100 includes a manual safety disconnector (MSD) 150. The manual safety disconnector (MSD) 150 may be arranged between the first battery module 110 and the second battery module 120 and may connect or separate the first battery module 110 and the second battery module 120 to or from each other.

The manual safety disconnector (MSD) 150 may be connected to contact terminals that may be manually connected or separated by a user to or from each other. For example, the user manually inserts the manual safety disconnector (MSD) 150 between the contact terminals, thereby connecting the first battery module 110 and the second battery module 120 to each other. The user manually separates the manual safety disconnector (MSD) 150 from the contact terminals, so that the first battery module 110 and the second battery module 120 may be separated from each other. The manual safety disconnector (MSD) 150 may include a second fuse FS2.

A failure may occur in the battery system 100. In this case, the battery system 100 needs to be disassembled to check the cause of the failure or repair. When disassembling the battery system 100, the user may manually separate the manual safety disconnector (MSD) 150 for safety and then start disassembling the battery system 100.

The manual safety disconnector (MSD) 150 manually disconnects a conductive path between the battery modules 110 and 120 connected in series with each other, thereby guaranteeing the user's safety during disassembling and repairing of the battery system 100 and replacement of the battery modules 110 and 120 and preventing an accident such as a short circuit between the first and second battery modules 110 and 120 that may occur in the battery system 100.

However, since the manual safety disconnector (MSD) 150 needs to be connected between the first and second battery modules 110 and 120, the overall cost may be increased, the overall volume may be increased, and the complexity of the battery system 100 may be increased. WO 2018/100531, US 2011/285351, CN 110466 and US 2009/208821 all provide disclosures related to batteries.

### SUMMARY

According to an aspect, there is provided a battery system according to Claim 1. Details of embodiments are provided in the dependent claims. One or more embodiments include a battery system from which a manual safety disconnector (MSD) according to the related art has been removed.

According to one or more embodiments, a battery system includes a first battery module including a plurality of first battery cells, a second battery module including a plurality of second battery cells, and a battery disconnection unit (BDU) connected between the first battery module and the second battery module. The battery disconnection unit (BDU) may include a first main switch connected in series between the plurality of first battery cells and the plurality of second battery cells, and a precharge switch and a precharge resistor connected in parallel with the first main switch and connected in series with each other.

The battery system may further include a first battery terminal connected to the first battery module and a second battery terminal connected to the second battery module. The battery disconnection unit (BDU) may further include a second main switch connected in series between the plurality of second battery cells and the second battery terminal.

The battery system may further include a battery management unit configured to control the first main switch, the second main switch, and the precharge switch.

The first battery module may include a first module management unit configured to monitor the plurality of first battery cells, and the second battery module may include a second module management unit configured to monitor the plurality of second battery cells. The battery management unit may transmit/receive data to/from the first module management unit and the second module management unit.

The plurality of first battery cells included in the first battery module and the plurality of second battery cells included in the second battery module may have the same connection configuration.

A rated module voltage of the first battery module and a rated module voltage of the second battery module may have substantially the same magnitude.

Example embodiments will be described in more detail with reference to the accompanying drawings, so that features will be apparent to those skilled in the art.

At least some of the above features that accord with the invention and other features according to the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram of a battery system according to the related art; and
FIG. 2 is a block diagram of a battery system according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Now, example embodiments will be described in more detail with reference to the accompanying drawings. However, the example embodiments can be embodied in many forms and should not be considered as being limited to the embodiments described herein. However, the example embodiments can be embodied in many forms and should not be considered as being limited to the embodiments described herein.

The terms used in this application are only used to describe specific embodiments, and are not intended to limit the present disclosure. As used herein, the singular forms "a," "an," and the "the" are intended to include the plural forms as well, unless the context clearly indicates otherwise. It will be further understood that the terms "comprises" and/or "comprising" used herein specify the presence of stated features or components, but do not preclude the presence or addition of one or more other features or components. It will be understood that although the terms "first," "second," etc. may be used herein to describe various components, these components should not be limited by these terms. These terms are used only to distinguish one component from other components.

Hereinafter, embodiments will be described with reference to the accompanying drawings in which example embodiments are shown.

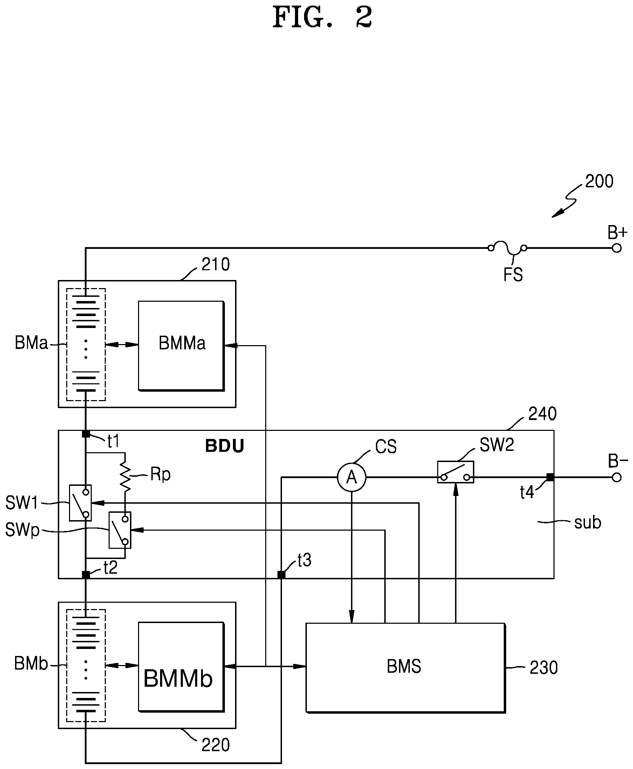

FIG. 2 is a block diagram of a battery system according to an embodiment.

Referring to FIG. 2, a battery system 200 may include a first battery module 210 including a plurality of first battery cells BMa, a second battery module 220 including a plurality of second battery cells BMb, and a battery disconnection unit (BDU) 240 connected between the first battery module 210 and the second battery module 220.

Throughout the specification, when reference is made to a component being connected between two terminals, it means that the component is electrically connected to and between both terminals, either directly or indirectly via another component. Connection between a terminal and a component or between two components has the same meaning mutatis mutandis.

The battery disconnection unit (BDU) 240 may include a first main switch SW1 connected in series between the first battery cells BMa of the first battery module 210 and the second battery cells BMb of the second battery module 220, and a precharge switch SWp and a precharge resistor Rp connected in parallel with the first main switch SW1 and connected in series with each other.

The battery system 200 may include a first battery terminal B+ connected to the first battery module 210 and a second battery terminal B- connected to the second battery module 220. According to an embodiment, the first battery terminal B+ may have a higher electric potential than the second battery terminal B-. However, this is just an example and may be the opposite. According to an example, the second battery terminal B- may be connected to a ground. However, this just an example, and the first battery terminal B+ may be connected to the ground. In the following description, it is assumed that the first battery terminal B+ has a higher electric potential than the second battery terminal B-. A path between the first battery module 210 and the first battery terminal B+ is referred to as a high voltage path, and a path between the second battery module 220 and the second battery terminal B- is referred to as a low voltage path.

When the battery system 200 operates normally, a voltage between the first battery terminal B+ and the second battery terminal B- may be several hundred V or more. For example, the voltage between the first battery terminal B+ and the second battery terminal B- may have the magnitude of about 400 V to about 800 V. Hereinafter, the voltage between the first battery terminal B+ and the second battery terminal B- is referred to as a system voltage.

The first and second battery terminals B+ and B- may be connected to a load such as an electric motor, which is driven by using power stored in the battery system 200, or may be connected to power devices such as generators, rectifiers, or converters for supplying power to the battery system 200.

The first and second battery cells BMa and BMb in which power is stored, may be connected in series with each other to configure the first and second battery modules 210 and 220. The first and second battery cells BMa and BMb may be rechargeable secondary batteries. For example, the first and second battery cells BMa and BMb may include at least one selected from the group consisting of a lithium ion battery, a lithium polymer battery, a nickel cadmium battery, a nickel metal hydride (Ni-MH) battery, a nickel-zinc (Ni-Zn) battery, and a lead acid battery. The number of the first and second battery cells BMa and BMb of the battery system 200 and the connection configuration thereof may be determined according to a required output voltage and a charge/discharge capacity.

In FIG. 2, each of the first battery module 210 and the second battery module 220 is shown as being one. However, this is just an example, and each of the first battery module 210 and the second battery module 220 may include a plurality of battery modules.

The first battery module 210, the first main switch SW1 of the battery disconnection unit (BDU) 240, and the second battery module 220 may be connected in series with one another so that the electric potential of the first main switch SW1 of the battery disconnection unit (BDU) 240 with respect to the second battery terminal B- is approximately half of the electric potential of the first battery terminal B+, and a first module voltage of the first battery module 210 and a second module voltage of the second battery module 220 may have substantially the same magnitude.

According to an example, a rated module voltage of the first battery module 210 and a rated module voltage of the second battery module 220 may have substantially the same magnitude. The first and second battery modules 210 and 220 may have the rated module voltage with the same magnitude. According to another example, the first battery cells BMa of the first battery module 210 and the second battery cells BMb of the second battery module 220 may have the same specifications, the same number, and the same connection configuration. In this case, since an electric component, for example, a relay or a power semiconductor switch having a dielectric withstand of about half compared to the related art may be used in the first main switch SW1, manufacturing cost may be reduced.

The first main switch SW1 of the battery disconnection unit (BDU) 240 may connect or disconnect a path between the first battery module 210 and the second battery module 220. The first main switch SW1 may be shorted so as to charge or discharge the first battery cells BMa and the second battery cells BMb. When the first battery cells BMa and the second battery cells BMb are over-charged or discharged or in a high temperature state, the first main switch SW1 may be opened to protect the first battery cells BMa and the second battery cells BMb.

The precharge switch SWp and the precharge resistor Rp may prevent the battery system 200, the load or the power device from being damaged by an inrush current that flows when the load or power device is suddenly connected to the first and second battery terminals B+ and B-. The precharge switch SWp is first shorted before the first main switch SW1 is shorted, so that the magnitude of the inrush current may be limited by the precharge resistor Rp. When current flowing through the precharge resistor Rp is less than or equal to a preset magnitude, the first main switch SW1 may be shorted, and the precharge switch Swp may be opened.

In an embodiment, the battery disconnection unit (BDU) 240 may further include a second main switch SW2 arranged on a low voltage path between the second battery cells BMb and the second battery terminal B-. When the first main switch SW1 is not controlled by a failure or the like, the second main switch SW2 may be opened to protect the battery system 200. Although the second main switch SW2 is arranged on the low voltage path, the second main switch SW2 may be arranged on the high voltage path.In an embodiment, the first main switch SW1, the second main switch SW2, and the precharge switch SWp may be configured as a relay switch or a power transistor.

In an embodiment, the battery disconnection unit (BDU) 240 may further include a current sensor CS arranged on the low voltage path between the second battery cells BMb and the second battery terminal B-. The current sensor CS may detect the magnitude of a charge/discharge current that flows through the second battery terminal B-, the second battery module 220, the first battery module 210, and the first battery terminal B+. The current sensor CS may output a signal corresponding to the magnitude of the charge/discharge current. The current sensor CS may include a shunt resistor, for example. In this case, the current sensor CS may output a voltage signal corresponding to the magnitude of the charge/discharge current. Although the current sensor CS is arranged on the low voltage path, the current sensor CS may be arranged on the high voltage path.

In an embodiment,he battery disconnection unit (BDU) 240 may include a substrate, sub, having first through fourth terminals t1 to t4. In an embodiment, the first terminal t1 may be connected to a negative terminal of the first battery cells BMa, and the second terminal t2 may be connected to a positive terminal of the second battery cells BMb. The third terminal t3 may be connected to the positive terminal of the second battery cells BMb, and the fourth terminal t4 may be connected to the second battery terminal B-. In an alternative embodiment, the polarities of the terminals of the battery cells may be the other way round. In embodiments where there is no second main switch, the second battery module may be connected between the second terminal t2 of the BDU and the second battery terminal.

In an embodiment, the first main switch SW1, the second main switch SW2, the precharge switch SWp, the precharge resistor Rp, and the current sensor CS may be mounted on the substrate sub. The first main switch SW1 may be connected between the first and second terminals t1 and t2. The precharge switch SWp and the precharge resistor Rp may be connected between the first and second terminals t1 and t2. The second main switch SW2 and the current sensor CS may be connected between the third and fourth terminals t3 and t4.

In an embodiment, the battery system 200 may further include a fuse FS so as to prevent an overcurrent from flowing. The fuse FS may be arranged on an overvoltage current. However, the fuse FS may be arranged on the low voltage path.

In an embodiment, the battery system 200 may further include a battery management unit 230 that controls the first main switch SW1, the second main switch SW2 and the precharge switch SWp and receives a signal corresponding to the magnitude of the charge/discharge current from the current sensor CS. For example, when the battery management unit 230 receives a signal from the current sensor CS, detects the magnitude of the charge/discharge current and the magnitude of the charge/discharge current exceeds a preset over-current setting value, at least one of the first main switch SW1 and the second main switch SW2 may be opened.

When the load or power device is connected to the first and second battery terminals B+ and B-, the battery management unit 230 may open the first main switch SW1, and the second main switch SW2 and the precharge switch SWp may be shorted. The battery management unit 230 may detect the magnitude of current that flows through the precharge resistor Rp by using the current sensor CS, and when the magnitude of the current is less than a preset setting value, the battery management unit 230 may short the first main switch SW1 and may open the precharge switch SWp.

In an embodiment, the first battery module 210 may include a first module management unit BMMa that monitors the first battery cells BMa. The second battery module 220 may include a second module management unit BMMb that monitors the second battery cells BMb.

Each of the first and second module management units BMMa and BMMb may detect a cell voltage and temperature of each of the first and second battery cells BMa and BMb and may equally adjust cell voltages of the first and second battery cells BMa and BMb according to a preset cell balancing algorithm. For this cell balancing operation, each of the first and second module management units BMMa and BMMb may include a cell balancing circuit.

The first and second module management units BMMa and BMMb may transmit monitoring data to the battery management unit 230 and may receive a control command or the like from the battery management unit 230. The first and second module management units BMMa and BMMb and the battery management unit 230 may perform data communication with each other by using a controller area network (CAN) bus, for example.

In an embodiment, the battery management unit 230 may stably disconnect a high voltage and a high current input and output between the battery system 200 and power devices such as an inverter and a DC/DC converter by using the battery disconnection unit (BDU) 240. When an overcurrent occurs due to unintended external collision or internal circuit malfunction, the battery management unit 230 may quickly detect the overcurrent by using the current sensor CS and may quickly open the first and second main switches SW1 and SW2, thereby protecting the life of the battery system 200.

The battery management unit 230 may monitor the cell voltages of the first and second battery cells BMa and BMb, the module voltages of the first and second battery modules 210 and 220, the system voltages between the first and second battery terminals B+ and B-, and temperatures of the first and second battery modules 210 and 220. The battery management unit 230 may control and manage the overall operation of the battery system 200 according to a preset management control algorithm.

When the load and the power devices are separated from the first and second battery terminals B+ and B-, the battery management unit 230 may open the first main switch SW1 and the precharge switch SWp, thereby electrically separating the first battery module 210 and the second battery module 220 from each other. According to another example, the battery management unit 230 may open the second main switch SW2.

The user needs to disassemble the battery system 200 for reasons such as maintenance such as that a failure occurs in the battery system 200 or that at least one of the battery modules 210 and 220 is deteriorated and needs to be replaced. The user may separate the load and the power devices connected to the battery system 200 from the first and second battery terminals B+ and B-. The battery management unit 230 may detect separation of the load and the power devices to open the first main switch SW1 and the precharge switch SWp and to electrically separate the first battery module 210 and the second battery module 220 from each other, thereby performing the function of the manual safety disconnector (MSD) 150 described with reference to FIG. 1. The user may perform tasks such as checking the battery system 200 or replacing the battery modules 210 and 220.

In the related art, the user needs to manually separate the manual safety disconnector (MSD) 150. However, according to the present disclosure, the first battery module 210 and the second battery module 220 may be automatically separated from each other by the battery disconnection unit (BDU) 240, so that operation convenience may be enhanced.

In addition, the position of the battery disconnection unit (BDU) 240 may be changed between the first and second battery modules 210 and 220, so that the function of the manual safety disconnector (MSD) 150 according to the related art may be performed by the battery disconnection unit (BDU) 240. Thus, the battery system 200 may be not equipped with the manual safety disconnector (MSD) 150. Thus, manufacturing cost may be reduced by the cost of a manual safety disconnector (MSD), and volume may be reduced.

In a battery system according to the present embodiment, the function of the manual safety disconnector (MSD) of a battery system according to the related art is replaced with a switch controlled by a battery management unit so that cost, complexity, and volume may be reduced. In addition, since there is no need to manually separate the battery modules, convenience and safety of operation are increased together.

The specific implementations shown and described herein are examples for description and are not intended to limit the scope of the embodiments in any way. For the sake of brevity, conventional electronics, control systems, software development and other functional aspects of the systems (and components of the individual operating components of the systems) may not be described in detail. Furthermore, the connection lines, or connectors shown in the various figures presented are intended to represent examples of functional relationships and/or physical or logical couplings between the various elements. It should be noted that many alternative or additional functional relationships, physical connections or logical connections may be present in a practical device. Moreover, no item or component is essential to the practice of the present disclosure unless the element is specifically described as "essential" or "critical".

In the specification of embodiments (in particular, claims), the use of the terms "a" and "an" and "the" and similar referents in the context of describing the present disclosure (especially in the context of the following claims) are to be construed to cover both the singular and the plural. Furthermore, recitation of ranges of values herein are merely intended to serve as a shorthand method of referring individually to each separate value falling within the range, unless otherwise indicated herein, and each separate value is incorporated into the specification as if it were individually recited herein. Finally, the steps of all methods described herein can be performed in any suitable order unless otherwise indicated herein or otherwise clearly contradicted by context. The present disclosure is not necessarily limited according to the description order of the steps. The use of any and all examples, or exemplary language (e.g., "such as") provided herein, is intended merely to better illuminate the invention and does not pose a limitation on the scope of the invention unless otherwise claimed. Numerous modifications and adaptations will be readily apparent to those skilled in this art without departing from the scope of the claims.

Although example embodiments have been presented herein and certain terms have been used, these terms are not intended to be limiting and should be interpreted as being general and illustrative. In some examples, although it will be apparent to those skilled in the art at the time of filing this application, the features, and/or components described in connection with a specific embodiment may be used alone, unless specifically stated otherwise, or may be used together with the features, and/or components described in connection with other embodiments.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein. However, the scope of the invention is solely defined by the appended claims.

## Claims

1. A battery system (200) comprising:
a first battery terminal (B+);
a second battery terminal (B-);
a first battery module (210) comprising a plurality of first battery cells (BMa) and a first module management unit (BMMa) configured to monitor the plurality of first battery cells and connected to the first battery terminal;
a second battery module (220) comprising a plurality of second battery cells (BMb) and a second module management unit (BMMb) configured to monitor the plurality of second battery cells, and connected to the second battery terminal;
a battery management unit (230) configured to transmit data to and receive data from the first module management unit and the second module management unit; and
a battery disconnection unit, BDU, connected between the first and second battery modules and between the second battery module and the second battery terminal,
wherein the BDU comprises:
a substrate including a first terminal (t1) connected to a negative terminal of the first battery module, a second terminal (t2) connected to a positive terminal of the second battery module, a third terminal (t3) connected to a negative terminal of the second battery module, and a fourth terminal (t4) connected to the second battery terminal;
a first main switch (SW1) mounted on the substrate and connected between the first terminal and the second terminal;
a precharge switch (SWp) and a precharge resistor (Rp) mounted on the substrate and connected in series between the first terminal and the second terminal; and
a second main switch (SW2) mounted on the substrate and connected between the third terminal and the fourth terminal, and
wherein the battery management unit is configured to control the first main switch, the second main switch, and the precharge switch.

2. A battery system of Claim 1, wherein the BDU further comprises a current sensor (CS) mounted on the substrate and connected in series with the second main switch.

3. The battery system of claim 1 or claim 2, wherein the plurality of first battery cells included in the first battery module and the plurality of second battery cells included in the second battery module have the same connection configuration.

4. The battery system of any of claims 1 to 3, wherein a rated module voltage of the first battery module and a rated module voltage of the second battery module have substantially the same magnitude.

## Patentansprüche

1. Batteriesystem (200), Folgendes umfassend:
einen ersten Batterieanschluss (B+);
einen zweiten Batterieanschluss (B-);
ein erstes Batteriemodul (210), umfassend eine Vielzahl von ersten Batteriezellen (BMa) und eine erste Modulverwaltungseinheit (BMMa), die konfiguriert ist, um die Vielzahl von ersten Batteriezellen zu überwachen, und die mit dem ersten Batterieanschluss verbunden ist;
ein zweites Batteriemodul (220), umfassend eine Vielzahl von zweiten Batteriezellen (BMb) und eine zweite Modulverwaltungseinheit (BMMb), die konfiguriert ist, um die Vielzahl von zweiten Batteriezellen zu überwachen, und die mit dem zweiten Batterieanschluss verbunden ist;
einer Batterieverwaltungseinheit (230), die konfiguriert ist, um Daten an die erste Modulverwaltungseinheit und an die zweite Modulverwaltungseinheit zu senden und Daten von diesen zu empfangen; und
eine Batterietrenneinheit, BDU, die zwischen dem ersten und dem zweiten Batteriemodul und zwischen dem zweiten Batteriemodul und dem zweiten Batterieanschluss angeschlossen ist,
wobei die BDU Folgendes umfasst:
ein Substrat einschließlich eines ersten Anschlusses (11), der mit einem negativen Anschluss des ersten Batteriemoduls verbunden ist, eines zweiten Anschlusses (t2), der mit einem positiven Anschluss des zweiten Batteriemoduls verbunden ist, eines dritten Anschlusses (t3), der mit einem negativen Anschluss des zweiten Batteriemoduls verbunden ist, und eines vierten Anschlusses (t4), der mit dem zweiten Batterieanschluss verbunden ist;
einen ersten Hauptschalter (SW1), der auf dem Substrat montiert ist und zwischen dem ersten Anschluss und dem zweiten Anschluss angeschlossen ist;
einen Vorladeschalter (SWp) und einen Vorladewiderstand (Rp), die auf dem Substrat montiert und in Reihe zwischen dem ersten Anschluss und dem zweiten Anschluss angeschlossen sind; und
einen zweiten Hauptschalter (SW2), der auf dem Substrat montiert und zwischen dem dritten Anschluss und dem vierten Anschluss angeschlossen ist, und
wobei die Batterieverwaltungseinheit konfiguriert ist, um den ersten Hauptschalter, den zweiten Hauptschalter und den Vorladeschalter zu steuern.

2. Batteriesystem nach Anspruch 1, wobei die BDU ferner einen Stromsensor (CS) umfasst, der auf dem Substrat montiert und in Reihe mit dem zweiten Hauptschalter angeschlossen ist.

3. Batteriesystem nach Anspruch 1 oder Anspruch 2, wobei die Vielzahl von ersten Batteriezellen, die in dem ersten Batteriemodul eingeschlossen sind, und die Vielzahl von zweiten Batteriezellen, die in dem zweiten Batteriemodul eingeschlossen sind, die gleiche Verbindungskonfiguration aufweisen.

4. Batteriesystem nach einem der Ansprüche 1 bis 3, wobei eine Nennmodulspannung des ersten Batteriemoduls und eine Nennmodulspannung des zweiten Batteriemoduls im Wesentlichen die gleiche Größe aufweisen.

## Revendications

1. Système de batterie (200) comprenant :
une première borne de batterie (B+) ;
une deuxième borne de batterie (B-) ;
un premier module de batterie (210) comprenant une pluralité de premières cellules de batterie (BMa) et une première unité de gestion de module (BMMa) configurée pour surveiller la pluralité de premières cellules de batterie et connectée à la première borne de batterie ;
un deuxième module de batterie (220) comprenant une pluralité de deuxièmes cellules de batterie (BMb) et une deuxième unité de gestion de module (BMMb) configurée pour surveiller la pluralité de deuxièmes cellules de batterie, et connectée à la deuxième borne de batterie ;
une unité de gestion de batterie (230) configurée pour transmettre des données à et recevoir des données de la première unité de gestion de module et de la deuxième unité de gestion de module ; et
une unité de déconnexion de batterie, BDU, connectée entre les premier et deuxième modules de batterie et entre le deuxième module de batterie et la deuxième borne de batterie,
dans lequel la BDU comprend :
un substrat incluant une première borne (t1) connectée à une borne négative du premier module de batterie, une deuxième borne (t2) connectée à une borne positive du deuxième module de batterie, une troisième borne (t3) connectée à une borne négative du deuxième module de batterie, et une quatrième borne (t4) connectée à la deuxième borne de batterie ;
un premier interrupteur principal (SW1) monté sur le substrat et connecté entre la première borne et la deuxième borne ;
un interrupteur de précharge (SWp) et une résistance de précharge (Rp) montés sur le substrat et connectés en série entre la première borne et la deuxième borne ; et
un deuxième interrupteur principal (SW2) monté sur le substrat et connecté entre la troisième borne et la quatrième borne, et
dans lequel l'unité de gestion de batterie est configurée pour commander le premier interrupteur principal, le deuxième interrupteur principal et l'interrupteur de précharge.

2. Système de batterie selon la revendication 1, dans lequel la BDU comprend en outre un capteur de courant (CS) monté sur le substrat et connecté en série au deuxième interrupteur principal.

3. Système de batterie selon la revendication 1 ou la revendication 2, dans lequel la pluralité de premières cellules de batterie incluses dans le premier module de batterie et la pluralité de deuxièmes cellules de batterie incluses dans le deuxième module de batterie ont la même configuration de connexion.

4. Système de batterie selon l'une quelconque des revendications 1 à 3, dans lequel une tension nominale de module du premier module de batterie et une tension nominale de module du deuxième module de batterie ont sensiblement la même grandeur.
